(19) Europäisches Patentamt
European Patent Office
Office européen des brevets

(11) **EP 1 656 566 B1**

(12) **FASCICULE DE BREVET EUROPEEN**

(45) Date de publication et mention
de la délivrance du brevet:
**22.03.2017 Bulletin 2017/12**

(21) Numéro de dépôt: **04786325.3**

(22) Date de dépôt: **18.08.2004**

(51) Int Cl.:
*G02B 21/00* (2006.01)    *G01R 29/08* (2006.01)
*G01R 31/308* (2006.01)

(86) Numéro de dépôt international:
**PCT/FR2004/002159**

(87) Numéro de publication internationale:
**WO 2005/022179 (10.03.2005 Gazette 2005/10)**

(54) **DISPOSITIF ET PROCEDE DE DETECTION ET DE MESURE NON INVASIVES D'UN CHAMP ELECTRIQUE**

VORRICHTUNG UND VERFAHREN ZUR DETEKTION UND NICHTINVASIVEN MESSUNG EINES ELEKTRISCHEN FELDES

NON-INVASIVE ELECTRIC-FIELD-DETECTION DEVICE AND METHOD

(84) Etats contractants désignés:
**AT BE BG CH CY CZ DE DK EE ES FI FR GB GR HU IE IT LI LU MC NL PL PT RO SE SI SK TR**

(30) Priorité: **22.08.2003 FR 0310115**

(43) Date de publication de la demande:
**17.05.2006 Bulletin 2006/20**

(73) Titulaires:
• **CENTRE NATIONAL DE LA RECHERCHE SCIENTIFIQUE -CNRS-**
**75794 Paris Cedex 16 (FR)**
• **ECOLE NORMALE SUPERIEURE DE CACHAN**
**94235 Cachan (FR)**

(72) Inventeurs:
• **ZYSS, Joseph**
**F-92330 Sceaux (FR)**
• **TOURY, Timothée, Pol, Jean**
**F-08090 Tournes (FR)**

(74) Mandataire: **Regimbeau**
**20, rue de Chazelles**
**75847 Paris Cedex 17 (FR)**

(56) Documents cités:
**WO-A-01/35325**

• CHMELIK R: "HOLOGRAPHIC CONFOCAL MICROSCOPY" PROCEEDINGS OF THE SPIE, SPIE, BELLINGHAM, VA, US, vol. 4356, 12 septembre 2000 (2000-09-12), pages 118-123, XP008000246 ISSN: 0277-786X
• CHIMELIK R ET AL: "Surface profilometry by a holographic confocal microscopy" OPTICA APPLICATA, 2003, TECH. UNIV. WROCLAW, POLAND, vol. 33, no. 2-3, 2003, pages 381-389, XP008030404 ISSN: 0078-5466
• PUDNEY C ET AL: "A 3D local energy surface detector for confocal microscope images" INTELLIGENT INFORMATION SYSTEMS, 1995. ANZIIS-95. PROCEEDINGS OF THE THIRD AUSTRALIAN AND NEW ZEALAND CONFERENCE ON PERTH, WA, AUSTRALIA 27 NOV. 1995, NEW YORK, NY, USA,IEEE, US, 1995, pages 7-12, XP010295560 ISBN: 0-86422-430-3
• MARTIN G ET AL: "Reflection second harmonic generation scanning microscope" E-MRS (EUROPEAN MATERIALS RESEARCH SOCIETY) 2001 SPRING MEETING. SPRING CONFERENCE, SYMPOSIUM R: NOVEL ORGANIC MATERIAL AND TECHNOLOGICAL ADVANCES FOR PHOTONICS, STRASBOURG, FRANCE, 5-8 JUNE 2001, vol. 127, no. 1-3, 26 mars 2002 (2002-03-26), pages 105-109, XP001189215 Synthetic Metals, 26 March 2002, Elsevier, Switzerland ISSN: 0379-6779

# Description

La présente invention est relative aux dispositifs et procédés de détection et cartographie quantitatives et non invasives d'un champ ou potentiel électrique ou encore de leurs dérivées spatiales et/ou temporelles dans un milieu optiquement actif, éventuellement structurellement connu. Dans ce document, on désigne par "milieu optiquement actif", un milieu présentant des propriétés électro-optiques et plus particulièrement un milieu présentant un effet électro-optique linéaire (dit effet Pockels), ou un effet électro-optique quadratique dont le seuil de manifestation est toutefois plus élevé que dans le cas linéaire, tout en restant compatible avec l'usage de lasers de puissance à impulsions brèves.

En particulier, l'invention concerne un dispositif comprenant :

- une source optique pour éclairer au moins une zone à sonder du milieu avec un faisceau lumineux dont le parcours définit un axe optique, et
- des moyens de cartographie du déphasage du faisceau lumineux, induit par un champ ou un potentiel électrique, ou leurs dérivées, dans la zone à sonder.

Le document US-A-5 394 098 décrit un exemple d'un tel dispositif utilisé pour tester des composants optoélectroniques. Dans ce dispositif, la source optique est un laser et les moyens utilisés de cartographie du déphasage du faisceau lumineux consistent en un interféromètre. Le milieu ayant des propriétés électro-optiques est constitué d'une couche d'un polymère approprié recouvrant au moins la partie du composant que l'on veut tester.

Ce type de dispositif présente cependant l'inconvénient de ne permettre la mesure de champs électriques qu'en surface du fait de la dissociation, inhérente à cette approche, entre d'une part le milieu électro-optique inconnu, cible de la mesure et qui est lui-même le siège du champ électrique à déterminer (ou de la distribution électro-optique à déterminer ou d'une conjonction des deux), et d'autre part le milieu électro-optique artificiel introduit comme révélateur des lignes de champ émises par le milieu à sonder. En outre, l'utilisation de ce type de dispositif est limitée à la détection de champs électriques dans des milieux pouvant recevoir des traitements de type dépôt en couche mince, tels que ceux généralement utilisés dans les technologies de fabrication des composants opto-électroniques. Ce type de dispositif ne peut pas être utilisé en particulier pour la détection de champs électriques en volume dans des milieux biologiques.

On connaît par ailleurs du document « Holographic Confocal Microscopy », Chmelik R., Proceedings of the SPIE, SPIE, BELLINGHAM, VA, US, vol. 4356, 2000-09-12, pp.118-123, un microscope holographique confocal permettant de réaliser une image d'un échantillon et d'obtenir des informations sur le déphasage à l'intérieur dudit échantillon.

La présente invention a notamment pour but de pallier aux inconvénients précités.

A cet effet, on prévoit selon l'invention, un dispositif de détection non invasive d'un champ ou d'un potentiel électrique, ou de leurs dérivées, dans un milieu présentant un effet électro-optique linéaire ou quadratique, qui, outre les caractéristiques déjà mentionnées, est caractérisé par le fait que les moyens de cartographie du déphasage du faisceau lumineux comprennent un microscope confocal, dans lequel est placée la zone à sonder de manière adaptée pour former une image d'un plan de la zone à sonder.

Grâce au microscope confocal, on peut obtenir une résolution spatiale tridimensionnelle. Il est ainsi possible de sonder le volume du milieu. Cette disposition permet de sonder des milieux, sans préparation particulière si le milieu est doté de propriétés électro-optiques. Il est aussi possible de doper le milieu avec des molécules, des ions, etc. ayant des propriétés électro-optiques ou conférant au milieu des propriétés électro-optiques, afin d'exacerber les propriétés électro-optiques du milieu, si celui-ci en est déjà doté, ou pour révéler la présence de champs électriques dans un milieu qui ne possède pas intrinsèquement de telles propriétés.

La nature des milieux sondés peut, grâce à l'invention, être très diverse. Outre les composants opto-électroniques déjà cités, il peut s'agir d'une distribution locale, par exemple une interface entre deux milieux diélectriques distincts éventuellement dépourvus chacun de toute activité électro-optique intrinsèque. L'interface entre les deux milieux à caractères individuellement non électro-optiques, induit alors une brisure structurelle de centrosymétrie au voisinage de la discontinuité et la possibilité d'un effet électro-optique. Selon un autre exemple de distribution locale des propriétés électro-optiques, le milieu est amorphe. Il s'agit par exemple d'une matrice polymère contenant une solution solide de molécules électro-optiques dispersées aléatoirement et qui ont été localement orientées selon un ordre statistique non-centrosymétrique (sous l'effet d'un champ électrique induit localement par une électrode adéquate ou par des champs optiques selon une configuration dite d'orientation tout optique qui agit localement à la focale des faisceaux orientateurs). On peut désigner de telles occurrences locales de propriétés électro-optiques sous les appellations suggestives de "surfaces électro-optiques" (cas de la distribution bidimensionnelle ou quasi-bidimensionnelle de type membrane) ou d'"îlots électro-optiques" (voxels) dans le cas d'inclusions de structures électro-optiques exogènes au milieu ambiant. Par exemple, il s'agit dans ce cas, d'inclusions de structures électro-optiques dans un film de type polymère amorphe dépourvu de propriétés électro-optiques intrinsèques (ces inclusions présentent des dimensions aux échelles nanométriques ou microniques ; ce sont par exemple des nanocristaux présentant des propriétés non linéaires quadratiques). On peut, à l'inverse, créer par désorientation axiale un défaut local d'effet électro-optique au sein d'une structure électro-optique initialement homogène (telle qu'obtenue par orientation quasi-uniforme sous champ électrique dans une configuration classique de type aiguille corona). L'invention a en particulier de l'intérêt dans deux situations symétriques. D'une part, elle permet, quand la distribution des propriétés électro-optiques est inconnue, de révéler la cartographie spatiale de cette distribution a priori inconnue par mise sous champ électrique avec un jeu d'électrodes simples permettant de maîtriser aussi bien que possible la distribution du champ au sein de l'échantillon. D'autre part, quand la distribution spatiale des propriétés électro-optiques est bien connue par d'autres moyens (par exemple dans le cas d'un procédé technologique d'élaboration contrôlée de cette distribution), l'invention permet de déterminer la cartographie du champ interne ou externe au sein de la distribution, celle-ci dépendant à la fois de cette distribution a priori connue des propriétés électro-optiques, mais également de la géométrie des électrodes au travers desquelles est appliqué un champ électrique externe. Dans certains cas intermédiaires, la connaissance, tant de la distribution du champ électrique que des propriétés électro-optiques des structures, s'avère limitée. L'invention permet alors de réaliser avec certitude, en amont de cette double inconnue, une cartographie du déphasage optique ressenti par l'onde incidente qui vient sonder le milieu. Pour progresser dans la levée des indéterminations, l'homme de l'art émet alors des hypothèses structurelles et/ou physiques soit sur la structure du milieu électro-optique, soit sur la distribution du champ, soit sur une conjonction des deux.

De même, grâce à l'invention, la résolution spatiale de la mesure des champs électriques n'est limitée que par l'optique utilisée.

Dans des modes de réalisation de l'invention, on peut éventuellement avoir recours en outre à l'une et/ou à l'autre des dispositions suivantes :

- les moyens de cartographie du déphasage du faisceau lumineux comprennent un interféromètre pour diviser le faisceau lumineux en un faisceau de référence et un faisceau sonde et mesurer le déphasage entre le faisceau de référence et le faisceau sonde après traversée de la zone à sonder, dans cet interféromètre, l'asservissement des longueurs respectives du faisceau de référence et du faisceau sonde est actif jusqu'à une fréquence de coupure fc et ces moyens de cartographie ayant une fréquence d'échantillonnage de signal fa supérieure à la fréquence de coupure fc ; la résolution temporelle de la détection de champs électriques n'est limitée que par celle de l'électronique et des capteurs opto-électroniques des moyens de cartographie du déphasage du faisceau lumineux ;

- il comporte des moyens de déplacement du milieu, selon les trois dimensions de l'espace, sous le faisceau sonde ;

- il comporte des moyens de balayage adaptés pour balayer, avec le faisceau lumineux, la zone à sonder et une zone de référence, avec une fréquence d'acquisition f d'images enregistrées par les moyens de mesure des variations de la phase du faisceau lumineux, supérieure à la fréquence de coupure fc.

- il comporte des moyens de balayage adaptés pour balayer, avec le faisceau lumineux, la zone à sonder et la zone de référence selon une première direction de l'espace à une fréquence fx et selon une deuxième direction de l'espace avec une fréquence fy, pour former une image de n pixels selon la première direction et m pixels selon la deuxième direction, les fréquences fx et fy étant choisies telles que fx=fy/n et fy=fa/m ; ainsi, on obtient une modulation de la fréquence de variation du signal correspondant au phénomène électro-optique observé, à une fréquence fx plus élevée et avantageusement plus élevée que la fréquence de coupure fc ; plus précisément, les moyens de balayage comprennent quatre déflecteurs acousto-optiques, deux pour défléchir le faisceau lumineux, en amont du microscope confocal, chacun respectivement dans l'une des première et deuxième directions de l'espace et deux pour redresser le faisceau lumineux chacun respectivement dans l'une des première et deuxième directions de l'espace, en aval du microscope confocal ; en fait, ces première et deuxième directions de l'espace sont perpendiculaires à l'axe optique ;

- au moins un déflecteur acousto-optique, en aval du microscope confocal, est réglé pour incliner l'ordre O du faisceau lumineux par rapport à l'axe optique, et conserver l'ordre 1 paraxial ; éventuellement une lunette de Galilée permet d'augmenter l'angle de déviation entre l'ordre 1 et l'axe optique ; et

- il comporte en outre, en amont du microscope confocal, des moyens de contrôle de la polarisation du faisceau lumineux en incidence sur la zone à sonder.

Selon un autre aspect, l'invention concerne un procédé de mise en oeuvre du dispositif selon l'invention. Il s'agit en particulier d'un procédé de détection non invasive d'un champ ou d'un potentiel électrique, ou de leurs dérivés, dans un milieu présentant un effet électro-optique linéaire ou quadratique, dans lequel :

- on éclaire avec une source optique au moins une zone à sonder du milieu avec un faisceau lumineux dont le parcours définit un axe optique,

- on réalise une cartographie du déphasage du faisceau lumineux, induit par un champ ou un potentiel électrique, ou leurs dérivées, dans la zone à sonder, caractérisé par le fait qu'on place la zone à sonder dans un microscope confocal, lui-même intercalé dans des moyens de cartographie du déphasage du faisceau lumineux, de manière adaptée pour former une image d'un plan de la zone à sonder.

Dans des modes de mise en oeuvre du procédé selon l'invention, on peut éventuellement avoir recours en outre à l'une ou à l'autre des dispositions suivantes :

- connaissant la distribution des propriétés électro-optiques du milieu, on réalise une cartographie du champ électrique dans le milieu ; ou
- on génère un champ électrique de configuration connue dans le milieu, de manière à révéler des propriétés électro-optiques du milieu.

D'autres aspects, buts et avantages de l'invention apparaîtront à la lecture de la description d'un de ses modes de réalisation.

L'invention sera également mieux comprise à l'aide des dessins, sur lesquels :

- la figure 1 est un schéma de principe d'un exemple de mode de réalisation d'un dispositif conforme à la présente invention ;
- les figures 2a à 2f représentent schématiquement quelques exemples d'applications du procédé selon l'invention ;
- la figure 3 représente schématiquement une variante du dispositif de la figure 1 ;
- la figure 4 représente schématiquement le balayage réalisé avec les moyens de balayage de la variante de la figure 3 ; et
- la figure 5 représente schématiquement une variante des dispositifs des figures 1 et 3.

Sur les différentes figures, les mêmes références désignent des éléments identiques ou similaires.

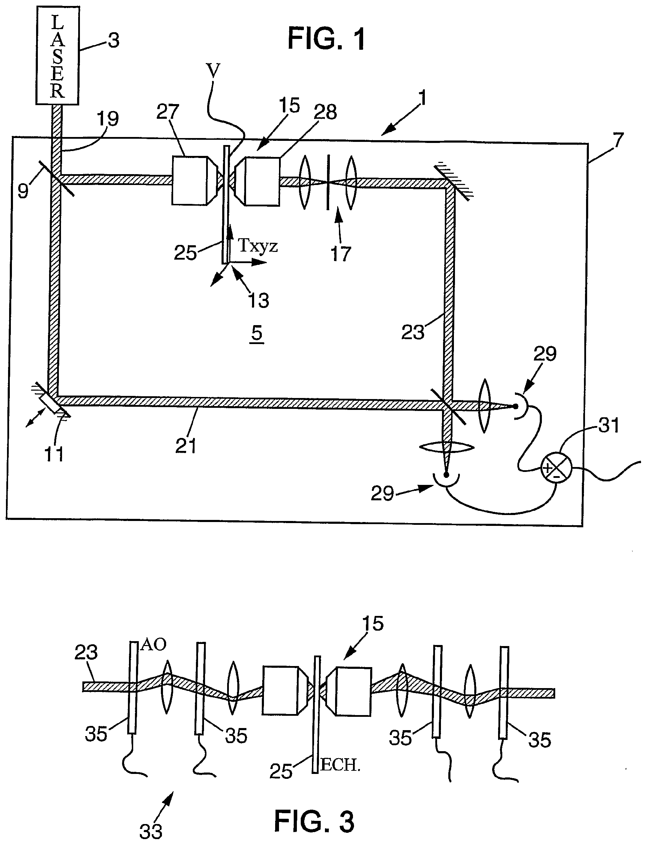

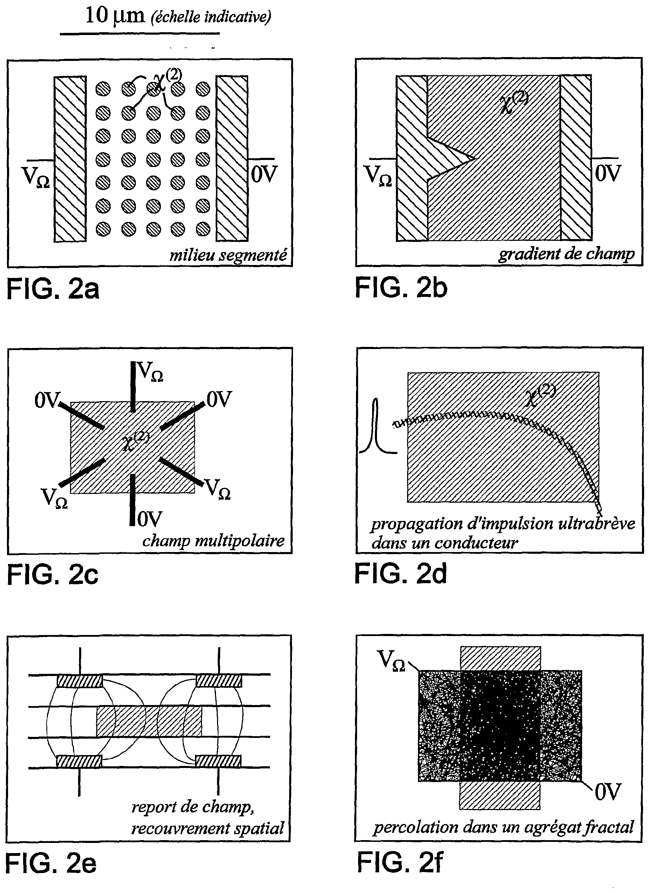

Un exemple de mode de réalisation du dispositif selon l'invention est présenté ci-dessous en relation avec les figures 1 et 2.

Comme représenté sur la figure 1, ce dispositif 1 est un microscope. Il comporte une source optique 3 et un interféromètre 5 constitutif de moyens de cartographie du déphasage du faisceau lumineux 7.

La source optique 3 est par exemple un laser. La longueur d'onde, la puissance et la nature (pulsée ou continue) de ce laser sont, bien entendu, à adapter au milieu à sonder et plus particulièrement aux espèces (molécules, ions, matériau électronique, etc.) optiquement actives révélant le champ électrique régnant dans ce milieu. Par exemple, pour une application à l'étude de composants opto-électroniques, on peut être amené à utiliser un laser He-Ne émettant à 632,8 nm, avec une puissance de quelques milliwatts.

L'interféromètre 5 comporte des moyens séparateurs 9, par exemple constitués d'une lame demi-onde et d'un polariseur, des miroirs asservis 11, un porte-échantillon 13, un microscope confocal 15 et des éléments optiques 17. Selon l'exemple de mode de réalisation du microscope présenté sur la figure 1, la détection de champs électriques est effectuée en transmission.

Bien entendu, il est à la portée de l'Homme du Métier de transposer cet enseignement pour effectuer cette détection en réflexion.

L'interféromètre 5 est monté en détection homodyne. Les moyens séparateurs 9 divisent le faisceau lumineux 19 émis par la source 3 en un faisceau de référence 21 et un faisceau sonde 23. La quadrature entre le faisceau de référence 21 et le faisceau sonde 23 est asservie à $\pi/2$ afin d'avoir accès à la variation relative de chemin optique. Un exemple d'asservissement des miroirs 11 est donné dans le mémoire de thèse doctorale de P. F. Cohadon (Laboratoire Kastler-Brossel, université Paris VI, Janvier 2000).

Le faisceau sonde 23 est focalisé, en une région d'un échantillon 25 monté dans le porte-échantillon 13, par l'intermédiaire d'une première optique 27 du microscope confocal 15. Une deuxième optique 28 du microscope confocal 15 collecte le faisceau lumineux transmis par l'échantillon 25 au niveau de cette région. Notons que, dans le cas d'une détection en réflexion, la réflexion peut éventuellement avoir lieu après la deuxième optique 28. Ce faisceau lumineux est alors filtré par les éléments optiques 17 comprenant un diaphragme qui intercepte tout signal ne passant pas par le foyer de la deuxième optique 28.

L'échantillon 25 est déplacé sous le faisceau sonde 23 grâce à une cale piézoélectrique qui déplace le porte-échantillon 13, dans les trois directions de l'espace. L'échantillon 25 est ainsi sondé en volume. Grâce à la cale piézoélectrique, il est possible d'effectuer une cartographie tridimensionnelle des champs électriques dans l'échantillon 25.

Le faisceau sonde 23 est détecté et enregistré par les moyens de cartographie du déphasage du faisceau lumineux 7. Plus précisément, ces moyens comportent des détecteurs 29 et une électronique de traitement et d'asservissement 31.

Les détecteurs 29 sont des photodiodes ultra-rapides à haute sensibilité telles que celles décrites dans le mémoire précité de la thèse doctorale de P. F. Cohadon. Ces détecteurs 29 servent aussi bien pour l'asservissement de la longueur relative des chemins optiques du faisceau de référence 21 et du faisceau sonde 23, que pour l'enregistrement du signal transmis par l'échantillon 25.

L'électronique de traitement et d'asservissement 31 est une électronique haute fréquence connue de l'Homme du Métier.

Le dispositif 1 tel que décrit ci-dessus peut être utilisé pour détecter des champs électriques dont les variations interviennent à une fréquence supérieure à la fréquence de coupure fc de l'asservissement de la longueur relative du faisceau de référence 21 et du faisceau sonde 23. Ainsi, il peut être utilisé pour la détection de signaux périodiques à haute fréquence et reproductibles. Par exemple, on excite le milieu à une fréquence fe et on mesure la variation de la phase du faisceau sonde par rapport à celle du faisceau de référence, à cette même fréquence fe. Il est éventuellement possible d'enregistrer aussi d'éventuelles réponses à d'autres fréquences qui peuvent renseigner sur le bruit, d'éventuels artefacts ou d'autres phénomènes non linéaires.

Il est ainsi possible de cartographier la réponse électrique à un signal d'excitation à la fréquence fe, endogène ou exogène, à toute fréquence supérieure à la fréquence de coupure fc.

Le dispositif décrit ci-dessus peut être mis en oeuvre dans de nombreuses applications.

A titre d'exemple, ce dispositif peut être mis en oeuvre dans un procédé, conforme à l'invention, de test de composants opto-électroniques.

Dans ce document, on désigne par composant opto-électronique, un composant électronique, microélectronique, optronique, ou bien encore un circuit comprenant des composants d'au moins l'un de ces types. Avantageusement, ces composants opto-électroniques présentent un effet électro-optique, au moins dans une partie de la zone à étudier et/ou à cartographier.

Plus particulièrement, dans ce type de procédé, on crée un potentiel d'excitation périodique et reproductible entre deux électrodes. La zone à sonder 34 comporte au moins une partie d'un composant opto-électronique auquel on applique ce potentiel.

Ce type de procédé peut être utilisé pour l'étude de milieux segmentés (voir figure 2a). Il permet alors de caractériser et de valider des procédés de fabrication de composants opto-électroniques à des échelles microniques et/ou submicroniques. Par exemple, on peut ainsi mesurer la résolution de zones gravées optiquement actives.

Ce type de procédé peut également être mis en oeuvre pour l'étude de gradient de champs électriques, notamment par mise en oeuvre d'électrodes de forme non triviale (figure 2b). Il s'agit par exemple d'électrodes multipolaires (cf. géométrie octupolaire telle que décrite dans l'article J. Zyss, Nonlinear Optics, vol. 1, p. 3, 1991 ; voir également figure 2c) auxquelles on applique un potentiel électrique. Une structure électro-optique de symétrie multipolaire adaptée à celle des électrodes permet de révéler la dérivée du champ ; par exemple la dérivée seconde du champ au centre d'un jeu d'électrode octupolaire tel que décrit à la figure 2b, le champ et sa première dérivée s'annulant par symétrie au centre de la micro-cellule d'orientation qui y est schématisée. Il est ainsi possible, grâce au procédé selon l'invention, de réaliser, la cartographie de gradients ou de courbures de champs électriques dans des zones optiquement actives. Ces cartes de champs peuvent être confrontées à des calculs pour les valider et affiner des modèles ou permettre au contraire de rechercher des configurations de champ dont les propriétés particulières sont difficilement accessibles par le calcul.

Ce type de procédé peut encore être mis en oeuvre pour l'étude de champs multipolaires (voir figure 2c). Dans ce cas, le potentiel est appliqué par l'intermédiaire d'au moins une électrode à symétrie multipolaire.

Des configurations d'électrodes à symétrie multipolaire donnent accès à des structures de champs multipolaires. De telles structures de champs multipolaires permettent d'accéder, par exemple, à la compréhension de la répartition en orientation de molécules sous l'influence de ces champs multipolaires.

Selon une autre application du procédé selon l'invention, on étudie la propagation d'impulsions dans un conducteur (fil, circuit intégré, composant opto-électronique, etc.). Ce conducteur est alors placé dans un milieu optiquement actif. En soumettant le milieu à des impulsions ultra courtes, il est possible d'avoir accès, par une étude fréquentielle de la propagation de ces impulsions dans le conducteur, à des régimes transitoires ultra brefs et à des informations sur la résistance ohmique du conducteur (voir figure 2d).

Selon encore une application du procédé selon l'invention, on étudie des phénomènes de report de champ, de recouvrement spatial, etc. Dans les composants opto-électroniques, le champ appliqué entre des électrodes n'a pas toujours une forme simple (voir figure 2e). Il peut en particulier se poser des problèmes de report de champ et de recouvrement spatial, à la fois statique ("poling" de la couche active du composant) et dynamique (champ de modulation). Grâce à la cartographie des champs électriques, obtenue avec le procédé selon l'invention, il est possible d'optimiser la forme et la structure de ces composants, pour aboutir, par exemple, à la réduction de la tension de commande.

Selon encore une autre application du procédé selon l'invention, on étudie des agrégats fractals et en particulier la percolation dans ces agrégats. Dans la zone à sonder 34, se trouve au moins une partie d'un agrégat fractal (voir figure 2f).

Selon une variante du dispositif 1 décrit ci-dessus, celui-ci comporte en outre des moyens de balayage 33 du faisceau sonde 23 sur l'échantillon 25.

Ces moyens de balayage 33 sont illustrés par la figure 3. Ils comportent quatre déflecteurs acousto-optiques 35.

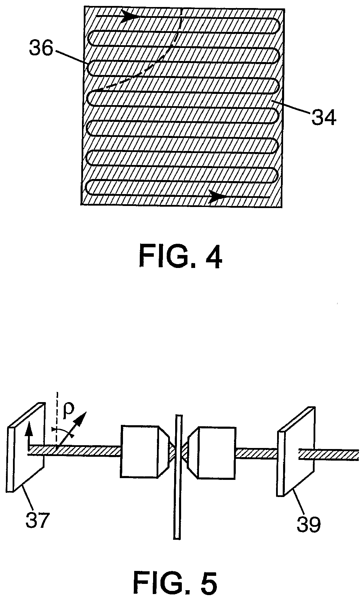

Deux de ces déflecteurs 35 sont placés en amont du microscope confocal 15 pour défléchir le faisceau sonde 23. Ces deux déflecteurs 35 en amont du microscope confocal sont réglés de manière à ne conserver que l'ordre 1 du faisceau parallèle à l'axe optique. L'un de ces deux déflecteurs génère un balayage de l'échantillon 25, avec le faisceau sonde 23, selon une première direction de l'espace, à une fréquence fx, qui est aussi la fréquence d'acquisition. L'autre de ces deux déflecteurs génère un balayage de l'échantillon 25, avec le faisceau sonde 23, selon une deuxième direction de l'espace, à une fréquence fy (voir figure 4). On forme ainsi une image de n pixels selon la première direction et m pixels selon la deuxième direction. Si la fréquence d'échantillonnage de signal est fa, les fréquences fx et fy sont choisies telles que fx=fy/n et fy=fa/m et qu'elles soient toutes deux supérieures à la fréquence de coupure fc.

Les deux autres des quatre déflecteurs 35 sont placés en aval du microscope confocal 15 et permettent de redresser le faisceau sonde 23, chacun respectivement dans l'une des première et deuxième directions de l'espace.

Les moyens de balayage 33 permettent de moduler, à la fréquence fx supérieure à la fréquence de coupure fc, le signal provenant des éventuels champs électriques détectés.

Comme illustré par la figure 4, on enregistre le signal transmis par l'échantillon 25 au cours du balayage selon les première et deuxième directions. Ce balayage passe par une zone à sonder 34 et une zone de référence 36. Cette zone de référence 36 peut être une zone de l'échantillon 25 lui-même dans laquelle ne varient pas les champs électriques. On soustrait alors de l'image du signal provenant des éventuels champs électriques détectés, une image de référence, c'est-à-dire une image de la phase sans potentiel ou avec un potentiel de référence ou de repos. On ramène ainsi, sur un fond noir, l'image du signal provenant des éventuelles variations détectées des champs électriques. On a donc réalisé une détection synchrone grâce à laquelle le bruit à relativement basse fréquence est éliminé.

La démodulation du signal provenant des éventuels champs électriques détectés, est réalisée au niveau de l'électronique de traitement et d'asservissement 31, d'une manière classique.

La variante décrite ci-dessus du dispositif selon l'invention peut être utilisée pour détecter des champs électriques dont les variations interviennent à une fréquence inférieure à la fréquence de coupure fc de l'asservissement de la longueur relative du faisceau de référence 21 et du faisceau sonde 23. Ainsi, il peut être utilisé pour la détection de signaux périodiques ou non, transitoires ou non et reproductibles ou non.

Cette variante trouve une application particulièrement intéressante dans le domaine de la biologie. Dans ce cas, la zone à sonder 34 comporte au moins une partie d'un milieu biologique naturel ou artificiel. En effet, par exemple, la zone à sonder 34 comporte au moins une partie d'une membrane biologique naturelle ou artificielle.

Ainsi, selon une application du procédé selon l'invention, on étudie des systèmes biomimétiques et par exemple la diffusion d'espèces moléculaires à travers des membranes artificielles. Des modifications de ces membranes dues à divers type de phénomènes (chimiques, biochimiques, électriques, rayonnement électromagnétique, etc.) peuvent être détectées grâce au dispositif selon l'invention. Ce type d'application peut s'étendre à l'étude de systèmes microfluidiques, de capsules, de vésicules, etc.

Aussi, selon une application du procédé selon l'invention, on étudie des systèmes biologiques tels que les neurones, les cellules zoologiques ou végétales, etc.

Dans le cadre de l'étude de neurones sains, la zone à sonder 34 comporte au moins une partie d'un neurone ou d'un réseau de neurones et le dispositif selon l'invention donne accès à la propagation des signaux électriques neuronaux et/ou interneuronaux, l'origine de ces signaux, etc. Le dispositif selon l'invention dans ce cas remplace avantageusement les techniques dites de "patch-clamp" pour lesquelles, par exemple pour un champ d'observation de $10 \times 10 \mu m^2$, il aurait fallu plusieurs dizaines de milliers d'électrodes, ou plus, pour obtenir une cartographie équivalente. Grâce au dispositif selon l'invention, on s'affranchit en outre des problèmes de contact, d'encombrement stérique, etc.

Le dispositif selon l'invention, permet aussi l'étude de neurones perturbés ou pathologiques, sclérosés, dégénérés, etc.

Grâce au dispositif selon l'invention, on peut aussi observer des phénomènes électriques à petites échelles, tels que les phénomènes de surtension ou ceux se produisant dans les réactions chimiques d'oxydo-réduction, dans les réacteurs chimiques à des échelles nanométriques ou non, au niveau de micelles, de complexes argilo-humique, etc. La zone à sonder 34 constitue alors au moins une partie d'un milieu chimique.

Selon encore une autre variante du dispositif conforme à l'invention, représentée sur la figure 5 et qui peut être combinée avec l'une et/ou l'autre des deux variantes déjà exposées, celui-ci comporte des moyens de contrôle de la polarisation 37 du faisceau sonde 23. Ces moyens de contrôle de la polarisation 37 permettent de faire varier de manière contrôlée l'état de polarisation du faisceau sonde 23 incident sur l'échantillon 25. Il s'agit par exemple de moyens de contrôle de la polarisation 37 adaptés pour obtenir une polarisation linéaire du faisceau sonde 23 dont l'angle p de polarisation dans le plan transverse à l'axe optique, est variable sur 360°. De tels moyens de contrôle de la polarisation 37 peuvent être constitués de n'importe quel dispositif connu de l'Homme du Métier, de préparation et de rotation d'un état de polarisation linéaire dans le plan transverse à l'axe optique. En particulier, ils peuvent comprendre une lame demi-onde et/ou un polariseur.

De tels moyens de contrôle de la polarisation 37 sont disposés en amont de la première optique 27 et des moyens de balayage 33. L'Homme du Métier est alors apte à mener les calculs correctifs nécessaires au passage de l'état de polarisation linéaire en amont de cette première optique 27, à l'état de polarisation elliptisé au niveau de l'échantillon 25. Un analyseur de polarisation 39 facultatif peut être placé à la sortie de la deuxième optique 28, en complément des moyens de contrôle de la polarisation 37.

Dans certains cas, que ce soit en électronique ou en biologie, le milieu doit être dopé avec des molécules ou des ions électro-optiques, afin d'exacerber les propriétés électro-optiques du milieu et/ou permettre d'observer des champs électriques dans des milieux dépourvus de telles propriétés.

A titre d'exemple de molécules électro-optiques, on cite les molécules suivantes :

- la molécule "DR1" (Dispersed Red One) est bien connue de l'Homme du Métier. Elle est plutôt utilisée pour l'étude de composants opto-électroniques de modulation et les systèmes biomimétiques ;
- la molécule "Cristal Violet" est aussi bien connue de l'Homme du Métier. Elle constitue un exemple d'octupôle. Elle est sensible aux gradients successifs du champ électrique et non au champ électrique lui-même. On n'est en effet pas limité dans la détection des champs électriques selon le procédé conforme à la présente invention, à des non-linéarités d'ordre 2, on peut utiliser des non linéarités d'ordre supérieur ;
- des molécules dérivées de la phtalocyanine par substitution périphérique avec des groupements donneurs et accepteurs d'électrons en géométrie non-centrosymétrique, sont également connues de l'Homme du Métier. Elles peuvent être utilisées pour l'étude de systèmes biologiques.

De nombreuses autres molécules peuvent être utilisées. Il peut s'agir en particulier de différentes formes des molécules indiquées ci-dessus ou dérivées de ces dernières.

Il a été décrit ci-dessus un mode de réalisation des moyens de balayage 33, mais de nombreux types de balayage peuvent être envisagés. Pour n'en citer que quelques-uns :

- Balayage rectangulaire : Le balayage est effectué sur une zone d'intérêt, comprenant la zone à sonder et la zone de référence, plus petite que la surface effectivement accessible. Ce type de balayage est en particulier intéressant si la zone à sonder est réduite, on peut alors en profiter pour balayer à plus haute fréquence avec la même résolution ou augmenter la résolution en resserrant les pixels ou toute solution intermédiaire.
- Balayage de plusieurs rectangles : Le balayage est effectué sur une zone correspondant à un ensemble de rectangles tels que ceux décrits au paragraphe précédent. La zone de référence peut être unique alors que les différentes zones à sonder correspondent à des rectangles différents. Ceci peut être utile si la zone à sonder ne peut être couverte par un seul rectangle.
- Balayage sur des surfaces de formes variées : Le balayage est effectué des surfaces circulaires, elliptiques, triangulaires, etc., ou sur une composition de ces surfaces.
- Balayage sur des surfaces complexes : Le balayage est effectué sur des surfaces aux formes complexes, telles que l'application le nécessite, par exemple pour l'étude de tout ou partie d'un composant opto-électronique ou d'un système biologique (neurone, membrane, membrane artificielle, par exemple du type couche de Langmuir-Blodgett, ...).
- Balayage paramétré : Le balayage est effectué selon des trajectoires avec des coordonnée x et y paramétrées comme suit :

$$x = \cos (w.n.t)$$

$$y = \cos (w.n.m.t)$$

où n et m sont sensiblement les nombres de pixels correspondant à une période d'acquisition respectivement selon les coordonnées x et y. Ce type de balayage permet de s'approcher au maximum des limites des modulateurs acousto-optiques. Bien entendu, on peut aussi ne conserver ce paramétrage que sur l'une des deux coordonnées.

Notons que la réalisation du système de commande de ces différents types de balayage sont connus de l'Homme du Métier.

## Revendications

1. Système comprenant un milieu présentant un effet électro-optique linéaire ou quadratique et un dispositif de détection non invasive d'un champ ou d'un potentiel électrique, ou de leurs dérivées, dans le milieu présentant un effet électro-optique linéaire ou quadratique, ce dispositif comprenant :

   - une source optique (3) pour éclairer au moins une zone à sonder du milieu avec un faisceau lumineux dont le parcours définit un axe optique,
   - des moyens de cartographie du déphasage du faisceau lumineux (7), induit par un champ ou un potentiel électrique, ou leurs dérivées, dans la zone à sonder, **caractérisé par le fait que** les moyens de cartographie du déphasage du faisceau lumineux (7) comprennent un microscope confocal (15), dans lequel est placée la zone à sonder de manière adaptée pour former une image d'un plan de la zone à sonder.

2. Système selon la revendication 1, dans lequel les moyens de cartographie du déphasage du faisceau lumineux (7) comprennent un interféromètre (5) pour diviser le faisceau lumineux (19) en un faisceau de référence (21) et un faisceau sonde (23) et mesurer le déphasage entre le faisceau de référence (21) et le faisceau sonde (23) après traversée de la zone à sonder, dans cet interféromètre (5), l'asservissement des longueurs respectives du faisceau de référence et du faisceau sonde est actif jusqu'à une fréquence de coupure fc et ces moyens de cartographie (7) ayant une fréquence d'échantillonnage de signal fa supérieure à la fréquence de coupure fc.

**3.** Système selon la revendication 2, comportant des moyens de déplacement du milieu, selon les trois dimensions de l'espace, sous le faisceau sonde (23).

**4.** Système selon l'une des revendications 2 et 3, comportant des moyens de balayage (33) adaptés pour balayer, avec le faisceau lumineux, la zone à sonder (34) et une zone de référence (36), avec une fréquence d'acquisition f d'images enregistrées par les moyens de mesure des variations de la phase du faisceau lumineux (7), supérieure à la fréquence de coupure fc.

**5.** Système selon la revendication 4, dans lequel les moyens de balayage (33) balayent la zone à sonder (34) et la zone de référence (36), selon une première direction de l'espace à une fréquence fx et selon une deuxième direction de l'espace avec une fréquence fy, pour former une image de n pixels selon la première direction et m pixels selon la deuxième direction, les fréquences fx et fy étant choisies telles que fx=fy/n et fy=fa/m.

**6.** Système selon la revendication 5, dans lequel, les moyens de balayage (33) comprennent quatre déflecteurs acousto-optiques, deux pour défléchir le faisceau lumineux, en amont du microscope confocal (15), chacun respectivement dans l'une des première et deuxième directions de l'espace et deux pour redresser le faisceau lumineux chacun respectivement dans l'une des première et deuxième directions de l'espace, en aval du microscope confocal (15).

**7.** Système selon la revendication 6, dans lequel au moins un déflecteur acousto-optique, en aval du microscope confocal (15), est réglé pour incliner l'ordre 0 du faisceau lumineux par rapport à l'axe optique, et conserver l'ordre 1 paraxial.

**8.** Système selon la revendication 7, comprenant une lunette de Galilée pour augmenter l'angle entre l'ordre 1 et l'axe optique.

**9.** Système selon l'une des revendications précédentes comportant en outre, en amont du microscope confocal (15), des moyens de contrôle de la polarisation (37) du faisceau lumineux en incidence sur la zone à sonder.

**10.** Procédé de détection non invasive d'un champ ou d'un potentiel électrique, ou de leurs dérivées, dans un milieu présentant un effet électro-optique linéaire ou quadratique, dans lequel :

> - on éclaire avec une source optique (3) au moins une zone à sonder du milieu avec un faisceau lumineux dont le parcours définit un axe optique,
> - on réalise une cartographie du déphasage du faisceau lumineux, induit par un champ ou un potentiel électrique, ou leurs dérivées, dans la zone à sonder, **caractérisé par le fait qu'**on place la zone à sonder dans un microscope confocal, lui-même intercalé dans des moyens de cartographie du déphasage du faisceau lumineux (7), de manière adaptée pour former une image d'un plan de la zone à sonder.

**11.** Procédé selon la revendication 10, dans lequel, connaissant la distribution des propriétés électro-optiques du milieu, on réalise une cartographie du champ électrique dans le milieu.

**12.** Procédé selon la revendication 10, dans lequel on génère un champ électrique de configuration connue dans le milieu, de manière à révéler des propriétés électro-optiques du milieu.

**13.** Procédé selon l'une des revendications 10 à 12, dans lequel on utilise un interféromètre (5) pour diviser le faisceau lumineux en un faisceau de référence (21) et un faisceau sonde (23) et mesurer le déphasage entre le faisceau de référence (21) et le faisceau sonde (23) après traversée de la zone à sonder, on asservit des longueurs respectives du faisceau de référence (21) et du faisceau sonde (23) à des moyens de photo-détection (29) et on acquiert, avec les moyens de photo-détection (29), des images à une fréquence d'échantillonnage de signal fa supérieure à la fréquence de coupure fc de l'asservissement des longueurs respectives du faisceau de référence et du faisceau sonde.

**14.** Procédé selon la revendication 13, dans lequel on déplace le milieu, selon les trois dimensions de l'espace, sous le faisceau sonde (23).

**15.** Procédé selon la revendication 14, dans lequel on excite le milieu à une fréquence fe et on mesure la variation de la phase du faisceau sonde (23) par rapport à celle du faisceau de référence (21), à cette même fréquence fe.

**16.** Procédé selon la revendication 13, dans lequel on balaye, avec le faisceau sonde (23), la zone à sonder (34) et une zone de référence (36), avec une fréquence d'acquisition f d'images enregistrées par les moyens de mesure des variations de la phase du faisceau lumineux (7), supérieure à la fréquence de coupure fc.

**17.** Procédé selon la revendication 16, dans lequel on balaye la zone à sonder (34) et la zone de référence (36), selon une première direction de l'espace à une fréquence fx et selon une deuxième direction de l'espace avec une fréquence fy, pour former une image de n pixels selon la première direction et m pixels selon la deuxième direction, les fréquences fx et fy étant choisies telles que fx=fy/n et fy=fa/m.

18. Procédé selon l'une des revendications 10 à 16, dans lequel on règle au moins un déflecteur acousto-optique en aval du microscope confocal (15), pour incliner l'ordre 0 du faisceau lumineux par rapport à l'axe optique, et conserver l'ordre 1 paraxial.

19. Procédé selon la revendication 18, dans lequel on augmente grâce à une lunette de Galilée, l'angle entre l'ordre 1 et l'axe optique.

20. Procédé selon l'une des revendications 10 à 19, dans lequel la zone à sonder comporte au moins une partie d'un composant opto-électronique auquel on applique un potentiel.

21. Procédé selon la revendication 20, dans lequel on applique le potentiel par l'intermédiaire d'au moins une électrode dont la forme est adaptée pour créer un gradient de champ électrique.

22. Procédé selon l'une des revendications 20 et 21, dans lequel on applique le potentiel par l'intermédiaire d'au moins une électrode multipolaire.

23. Procédé selon l'une des revendications 20 à 22, dans lequel on place le composant opto-électronique dans un milieu optiquement actif.

24. Procédé selon l'une des revendications 20 à 23, dans lequel on étudie la propagation d'une impulsion électrique dans le composant opto-électronique.

25. Procédé selon l'une des revendications 10 à 19, dans lequel la zone à sonder comporte au moins une partie d'un agrégat fractal.

26. Procédé selon l'une des revendications 10 à 19, dans lequel la zone à sonder comporte au moins une partie d'un milieu biologique.

27. Procédé selon la revendication 26, dans lequel la zone à sonder comporte au moins une partie d'une membrane biologique.

28. Procédé selon l'une des revendications 26 et 27, dans lequel la zone à sonder comporte au moins une partie d'un neurone, ou d'un réseau de neurones.

29. Procédé selon l'une des revendications 10 à 19, dans lequel la zone à sonder comporte au moins une partie d'une membrane artificielle.

30. Procédé selon l'une des revendications 10 à 19, dans lequel la zone à sonder constitue au moins une partie d'un milieu chimique.

31. Procédé selon l'une des revendications 10 à 30, dans lequel on dope le milieu avec des molécules ou des ions aux propriétés électro-optiques ou conférant au milieu des propriétés électro-optiques.

**Patentansprüche**

1. System umfassend ein Medium, das einen linearen oder quadratischen elektro-optischen Effekt und eine Vorrichtung zur nicht-invasiven Detektion eines elektrischen Feldes oder Potentials oder deren Ableitungen in dem Medium, das einen linearen oder quadratischen elektro-optischen Effekt aufweist, umfasst, wobei diese Vorrichtung Folgendes umfasst:

   - eine optische Quelle (3) zum Beleuchten wenigstens eines zu untersuchenden Bereichs des Mediums mit einem Lichtstrahl, dessen Verlauf eine optische Achse definiert,
   - Mittel zur Kartographie der Phasenverschiebung des Lichtstrahls (7), die durch ein elektrisches Feld oder Potential oder deren Ableitungen in dem zu untersuchenden Bereich induziert wird, **dadurch gekennzeichnet, dass** die Mittel zur Kartographie der Phasenverschiebung des Lichtstrahls (7) ein Konfokalmikroskop (15) umfassen, in dem der zu untersuchende Bereich auf eine Weise angeordnet ist, die geeignet ist, um ein Bild einer Ebene des zu untersuchenden Bereichs zu bilden.

2. System nach Anspruch 1, wobei die Mittel zur Kartographie der Phasenverschiebung des Lichtstrahls (7) ein Interferometer (5) umfassen, um den Lichtstrahl (19) in einen Referenzstrahl (21) und einen Untersuchungsstrahl (23) zu teilen und die Phasenverschiebung zwischen dem Referenzstrahl (21) und dem Untersuchungsstrahl (23) nach Durchqueren des zu untersuchenden Bereichs in diesem Interferometer (5) zu messen, wobei die Servosteuerung der jeweiligen Längen des Referenzstrahls und des Untersuchungsstrahls bis zu einer Sperrfrequenz fc aktiv ist und diese Kartographiemittel (7) eine Signalabtastfrequenz fa besitzen, die größer als die Sperrfrequenz fc ist.

3. System nach Anspruch 2, umfassend Mittel zum Bewegen des Mediums in den drei Dimensionen des Raums unter dem Untersuchungsstrahl (23).

4. System nach einem der Ansprüche 2 und 3, umfassend Abtastmittel (33), die geeignet sind, den zu untersuchenden Bereich (34) und einen Referenzbereich (36) mit dem Lichtstrahl abzutasten mit einer Frequenz f zur Aufnahme von Bildern, die von den Mitteln zum Messen der Phasenvariationen des Lichtstrahls (7) aufgezeichnet werden, die größer als die Sperrfrequenz fc ist.

5. System nach Anspruch 4, wobei die Abtastmittel (33) den zu untersuchenden Bereich (34) und den Referenzbereich (36) in eine erste Raumrichtung bei einer Frequenz fx und in eine zweite Raumrichtung mit einer Frequenz fy abtasten, um ein Bild aus n Pixeln in der ersten Richtung und m Pixeln in der zweiten Richtung zu bilden, wobei die Frequenzen fx und fy derart gewählt sind, dass fx = fy/n und fy = fa/m.

6. System nach Anspruch 5, wobei die Abtastmittel (33) vier akusto-optische Deflektoren umfassen, zwei zum Ablenken des Lichtstrahls vor dem Konfokalmikroskop (15), jeder in jeweils eine der ersten und zweiten Raumrichtung, und zwei zum Wiederausrichten des Lichtstrahls, jeder in jeweils eine der ersten und zweiten Raumrichtung, hinter dem Konfokalmikroskop (15).

7. System nach Anspruch 6, wobei wenigstens ein akusto-optischer Deflektor hinter dem Konfokalmikroskop (15) eingestellt ist, um die 0. Ordnung des Lichtstrahls in Bezug auf die optische Achse zu beugen und die achsenparallele 1. Ordnung aufrecht zu erhalten.

8. System nach Anspruch 7, das ein galileisches Fernrohr umfasst, um den Winkel zwischen der 1. Ordnung und der optischen Achse zu vergrößern.

9. System nach einem der vorstehenden Ansprüche, das des Weiteren vor dem Konfokalmikroskop (15) Mittel zum Steuern der Polarisation (37) des Lichtstrahls beim Einfall auf den zu untersuchenden Bereich umfasst.

10. Verfahren zur nicht-invasiven Detektion eines elektrischen Feldes oder Potentials oder deren Ableitungen in einem Medium, das einen linearen oder quadratischen elektro-optischen Effekt aufweist, wobei:

- mit einer optischen Quelle (3) wenigstens ein zu untersuchender Bereich des Mediums mit einem Lichtstrahl beleuchtet wird, dessen Verlauf eine optische Achse definiert,
- eine Kartographie der Phasenverschiebung des Lichtstrahls, die durch ein elektrisches Feld oder Potential oder deren Ableitungen in dem zu untersuchenden Bereich induziert wird, erfolgt, **dadurch gekennzeichnet, dass** der zu untersuchende Bereich in einem Konfokalmikroskop angeordnet wird, welches seinerseits zwischen Mitteln zur Kartographie der Phasenverschiebung des Lichtstrahls (7) eingefügt ist in einer Weise, die geeignet ist, um ein Bild einer Ebene des zu untersuchenden Bereichs zu bilden.

11. Verfahren nach Anspruch 10, wobei in Kenntnis der Verteilung der elektro-optischen Eigenschaften des Mediums eine Kartographie des elektrischen Feldes in dem Medium erfolgt.

12. Verfahren nach Anspruch 10, wobei ein bekanntes elektrisches Konfigurationsfeld in dem Milieu erzeugt wird, um elektro-optische Eigenschaften des Mediums aufzudecken.

13. Verfahren nach einem der Ansprüche 10 bis 12, wobei ein Interferometer (5) genutzt wird, um den Lichtstrahl in einen Referenzstrahl (21) und einen Untersuchungsstrahl (23) zu teilen und die Phasenverschiebung zwischen dem Referenzstrahl (21) und dem Untersuchungsstrahl (23) nach Durchqueren des zu untersuchenden Bereichs zu messen, jeweilige Längen des Referenzstrahls (21) und des Untersuchungsstrahls (23) mittels Lichtdetektionsmitteln (29) servogesteuert werden und mit den Lichtdetektionsmitteln (29) Bilder bei einer Signalabtastfrequenz fa erfasst werden, die größer als die Sperrfrequenz fc der Servosteuerung der jeweiligen Längen des Referenzstrahls und des Untersuchungsstrahls ist.

14. Verfahren nach Anspruch 13, wobei das Medium in den drei Dimensionen des Raums unter dem Untersuchungsstrahl (23) bewegt wird.

15. Verfahren nach Anspruch 14, wobei das Medium bei einer Frequenz fe erregt und die Phasenvariation des Untersuchungsstrahls (23) in Bezug auf jene des Referenzstrahls (21) bei derselben Frequenz fe gemessen wird.

16. Verfahren nach Anspruch 13, wobei der zu untersuchende Bereich (34) und ein Referenzbereich (36) mit dem Untersuchungsstrahl (23) abgetastet werden mit einer Frequenz f zur Aufnahme von Bildern, die von den Mitteln zum Messen der Phasenvariationen des Lichtstrahls (7) aufgezeichnet werden, die größer als die Sperrfrequenz fc ist.

17. Verfahren nach Anspruch 16, wobei der zu untersuchende Bereich (34) und der Referenzbereich (36) in eine erste Raumrichtung bei einer Frequenz fx und in eine zweite Raumrichtung mit einer Frequenz fy abgetastet werden, um ein Bild aus n Pixeln in der ersten Richtung und m Pixeln in der zweiten Richtung zu bilden, wobei die Frequenzen fx und fy derart gewählt sind, dass fx = fy/n und fy = fa/m.

**18.** Verfahren nach einem der Ansprüche 10 bis 16, wobei wenigstens ein akusto-optischer Deflektor hinter dem Konfokalmikroskop (15) geregelt wird, um die 0. Ordnung des Lichtstrahls in Bezug auf die optische Achse zu beugen und die achsenparallele 1. Ordnung aufrecht zu erhalten.

**19.** Verfahren nach Anspruch 18, wobei der Winkel zwischen der 1. Ordnung und der optischen Achse mithilfe eines galileischen Fernrohrs vergrößert wird.

**20.** Verfahren nach einem der Ansprüche 10 bis 19, wobei der zu untersuchende Bereich wenigstens einen Teil eines opto-elektronischen Bauteils umfasst, an dem ein Potential angelegt wird.

**21.** Verfahren nach Anspruch 20, wobei das Potential mittels wenigstens einer Elektrode angelegt wird, deren Form geeignet ist, einen elektrischen Feldgradienten zu erzeugen.

**22.** Verfahren nach einem der Ansprüche 20 und 21, wobei das Potential mittels wenigstens einer Multipolelektrode angelegt wird.

**23.** Verfahren nach einem der Ansprüche 20 bis 22, wobei das opto-elektronische Bauteil in einem optisch aktiven Medium angeordnet wird.

**24.** Verfahren nach einem der Ansprüche 20 bis 23, wobei die Ausbreitung eines elektrischen Impulses in dem opto-elektronischen Bauteil untersucht wird.

**25.** Verfahren nach einem der Ansprüche 10 bis 19, wobei der zu untersuchende Bereich wenigstens einen Teil eines fraktalen Aggregats umfasst.

**26.** Verfahren nach einem der Ansprüche 10 bis 19, wobei der zu untersuchende Bereich wenigstens einen Teil eines biologischen Mediums umfasst.

**27.** Verfahren nach Anspruch 26, wobei der zu untersuchende Bereich wenigstens einen Teil einer biologischen Membran umfasst.

**28.** Verfahren nach einem der Ansprüche 26 und 27, wobei der zu untersuchende Bereich wenigstens einen Teil eines Neurons oder eines Neuronennetzes umfasst.

**29.** Verfahren nach einem der Ansprüche 10 bis 19, wobei der zu untersuchende Bereich wenigstens einen Teil einer künstlichen Membran umfasst.

**30.** Verfahren nach einem der Ansprüche 10 bis 19, wobei der zu untersuchende Bereich wenigstens einen Teil eines chemischen Mediums bildet.

**31.** Verfahren nach einem der Ansprüche 10 bis 30, wobei das Medium mit Molekülen oder Ionen dotiert wird, die elektro-optische Eigenschaften haben oder dem Medium elektro-optische Eigenschaften verleihen.

**Claims**

**1.** System comprising a medium exhibiting a linear or quadratic electro-optic effect and a device for the non-invasive detection of an electric field or potential, or derivatives thereof, in the medium exhibiting a linear or quadratic electro-optical effect, this device comprising:

- an optical source (3) for illuminating at least one zone to be probed of the medium with a light beam, the path whereof defines an optical axis,
- means for mapping the phase-shift of the light beam (7), induced by an electric field or potential, or derivatives thereof, in the zone to be probed, **characterised in that** the light beam phase-shift mapping means (7) comprise a confocal microscope (15), wherein the zone to be probed is placed in a suitable manner to form an image of a plane of the zone to be probed.

**2.** System according to claim 1, wherein the light beam phase-shift mapping means (7) comprise an interferometer (5) for splitting the light beam (19) into a reference beam (21) and a probe beam (23) and measuring the phase-shift between the reference beam (21) and the probe beam (23) after passing through the zone to be probed, in said interferometer (5), the servo-control of the respective lengths of the reference beam and of the probe beam is active up to a cut-off frequency fc and these mapping means (7) having a signal sampling frequency fa greater than the cut-off frequency fc.

**3.** System according to claim 2, comprising means for moving the medium, along the three spatial dimensions, under the probe beam (23).

**4.** System according to any one of claims 2 and 3, comprising scanning means (33) suitable for scanning, with the light beam, the zone to be probed (34) and a reference zone (36), with an acquisition frequency f of images recorded by the light beam phase variation measurement means (7), greater than the cut-off frequency.

**5.** System according to claim 4, wherein the scanning means (33) scan the zone to be probed (34) and the reference zone (36), along a first spatial direction at a frequency fx and along a second spatial direction with a frequency fy, to form an image of n pixels along the first direction and m pixels along the second direction, the frequencies fx and fy being chosen such that fx=fy/n and fy=fa/m.

6. System according to claim 5, wherein, the scanning means (33) comprise four acousto-optic deflectors, two for deflecting the light beam, upstream from the confocal microscope (15), each respectively in one of the first and second spatial directions and two for rectifying the light beam each respectively in one of the first and second spatial directions, downstream from the confocal microscope (15).

7. System according to claim 6, wherein at least one acousto-optic deflector, downstream from the confocal microscope (15), is set to incline the 0 order of the light beam with respect to the optical axis, and keep the 1st order paraxial.

8. System according to claim 7, comprising a Galilean telescope for increasing the angle between the 1st order and the optical axis.

9. System according to any one of the preceding claims further comprising, upstream from the confocal microscope (15), means for controlling the polarisation (37) of the incident light beam on the zone to be probed.

10. Method for the non-invasive detection of an electric field or potential, or derivatives thereof, in a medium exhibiting a linear or quadratic electro-optic effect, wherein:

    - at least one zone to be probed of the medium with a light beam, the path whereof defines an optical axis, is illuminated with an optical source (3),
    - mapping of the phase-shift of the light beam, induced by an electric field or potential, or derivatives thereof, in the zone to be probed is performed, **characterised in that** the zone to be probed is placed in a confocal microscope, in turn inserted in light beam phase-shift mapping means (7), in a suitable manner to form an image of a plane of the zone to be probed.

11. Method according to claim 10, wherein, given the distribution of the electro-optic properties of the medium, mapping of the electric field in the medium is performed.

12. Method according to claim 10, wherein an electric field of known configuration is generated in the medium, so as to reveal electro-optic properties of the medium.

13. Method according to any of claims 10 to 12, wherein an interferometer (5) is used for splitting the light beam into a reference beam (21) and a probe beam (23) and measuring the phase-shift between the reference beam (21) and the probe beam (23) after passing through the zone to be probed, respective lengths of the reference beam and of the probe beam are servo-controlled by photo-detection means (29) and, with the photo-detection means (29), images are acquired at a signal sampling frequency fa greater than the cut-off frequency fc of the servo-control of the respective lengths of the reference beam and of the probe beam.

14. Method according to claim 13, wherein the medium is moved, along the three spatial dimensions, under the probe beam (23).

15. Method according to claim 14, wherein the medium is excited at a frequency fe and the phase variation of the probe beam (23) is measured with respect to that of the reference beam (21), at the same frequency fe.

16. Method according to claim 13, wherein the zone to be probed (34) and a reference zone (36), with an acquisition frequency f of images recorded by the light beam phase variation measurement means (7), greater than the cut-off frequency fc are scanned, with the probe beam (23).

17. Method according to claim 16, wherein the zone to be probed (34) and the reference zone (36) are scanned, along a first spatial direction at a frequency fx and along a second spatial direction with a frequency fy, to form an image of n pixels along the first direction and m pixels along the second direction, the frequencies fx and fy being chosen such that fx=fy/n and fy=fa/m.

18. Method according to any one of claims 10 to 16, wherein at least one acousto-optic deflector, downstream from the confocal microscope (15), is set to incline the 0 order of the light beam with respect to the optical axis, and keep the 1st order paraxial.

19. Method according to claim 18, wherein the angle between the 1st order and the optical axis is increased by means of a Galilean telescope.

20. Method according to any one of claims 10 to 19, wherein the zone to be probed comprises at least one part of an opto-electronic component to which a potential is applied.

21. Method according to claim 20, wherein the potential is applied via at least one electrode the shape whereof is suitable for creating an electric field gradient.

**22.** Method according to any one of claims 20 and 21, wherein the potential is applied via at least one multipolar electrode.

**23.** Method according to any one of claims 20 to 22, wherein the opto-electronic component is placed in an optically active medium.

**24.** Method according to any one of claims 20 to 23, wherein the propagation of an electric pulse in the opto-electronic component is studied.

**25.** Method according to any one of claims 10 to 19, wherein the zone to be probed comprises at least a part of a fractal aggregate.

**26.** Method according to one of claims 10 to 19, wherein the zone to be probed comprises at least a part of a biological fluid.

**27.** Method according to claim 26, wherein the zone to be probed comprises at least a part of a biological membrane.

**28.** Method according to any one of claims 26 and 27, wherein the zone to be probed comprises at least a part of a neuron, or of a neural network.

**29.** Method according to any one of claims 10 to 19, wherein the zone to be probed comprises at least a part of an artificial membrane.

**30.** Method according to any one of claims 10 to 19, wherein the zone to be probed forms at least a part of a chemical medium.

**31.** Method according to any one of claims 10 to 30, wherein the medium is doped with molecules or ions with electro-optic properties or giving the medium electro-optic properties.

# FIG. 1

# FIG. 3

10 μm *(échelle indicative)*

*milieu segmenté*

**FIG. 2a**

*gradient de champ*

**FIG. 2b**

*champ multipolaire*

**FIG. 2c**

*propagation d'impulsion ultrabrève dans un conducteur*

**FIG. 2d**

*report de champ, recouvrement spatial*

**FIG. 2e**

*percolation dans un agrégat fractal*

**FIG. 2f**

**FIG. 4**

**FIG. 5**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 5394098 A

**Littérature non-brevet citée dans la description**

- **CHMELIK R.** Holographic Confocal Microscopy. *Proceedings of the SPIE, SPIE, BELLINGHAM, VA, US,* 12 Septembre 2000, vol. 4356, 118-123
- **P. F. COHADON.** *Laboratoire Kastler-Brossel, université Paris VI,* Janvier 2000
- **J. ZYSS.** *Nonlinear Optics,* 1991, vol. 1, 3